# DEMANDE DE BREVET EUROPEEN

(11) **EP 0 828 345 A1**
(43) Date de publication de la demande: **11.03.1998**
(21) Numéro de dépôt: 97402062.0
(22) Date de dépôt: 04.09.1997
(51) Int. Cl.: H03G 11/00, H01P 1/202

(54) **Conducteur électrique protégé contre les perturbations électromagnétiques dépassant un seuil**

(30) Priorité: 09.09.1996 FR 9610962
(71) Demandeur: Alcatel Cable France, 92110 Clichy (FR)
(72) Inventeur: Lamesch, Stéphane, 92250 La Garenne Colombes (FR); Braut, Jean-Louis, 78400 Chatou (FR); Le Mehaute, Alain, 91190 Gif Sur Yvette (FR); Cottevieille, Denis, 93100 Montreuil Sous Bois (FR)
(74) Mandataire: Feray, Valérie

(57) **Abrégé**

Dispositif de transport d'énergie électrique ou de signal électrique comprenant une âme, un conducteur extérieur et, entre l'âme et le conducteur extérieur, un matériau diélectrique.

Ce dispositif est caractérisé en ce que le matériau diélectrique comprend, au moins en partie, un matériau (17') qui est isolant lorsque le champ électrique est inférieur à un seuil déterminé et est conducteur quand le champ électrique dépasse ce seuil, de façon à empêcher la transmission de signaux pour lesquels le champ électrique est supérieur audit seuil. L'âme présente une configuration à pointes (40, 41, 42) permettant d'augmenter localement la valeur du champ électrique et donc d'abaisser le seuil de champ électrique extérieur à partir duquel ledit matériau (17') devient conducteur.

L'invention s'applique à un câble ou à un connecteur protégé contre les surtensions.

## Description

L'invention est relative à un conducteur protégé contre les perturbations électromagnétiques.

Les conducteurs ou câbles de transmission d'énergie ou de signaux électriques sont susceptibles de véhiculer des perturbations électromagnétiques dommageables pour l'appareil (émetteur et/ou récepteur) auquel est connecté le câble ou connecteur.

Ces perturbations peuvent être de natures très diverses avec des fréquences et des amplitudes variables.

L'exemple le plus significatif est la foudre qui constitue une énergie électrique de grande amplitude et s'étendant sur un large spectre de fréquences. Par ailleurs, l'intensification des télécommunications provoque une augmentation des champs électromagnétiques parasites. Ces champs proviennent de sources diverses telles que des émetteurs radios, de télévision, de communications téléphoniques ou encore d'émissions radar. Les perturbations peuvent également provenir du réseau de distribution d'énergie électrique. Il peut aussi s'agir d'agressions intentionnelles.

Quelle que soit l'origine de la pollution, les champs parasites sont souvent détectés par les câbles fonctionnant en antennes réceptrices.

Jusqu'à présent, pour s'opposer à ces perturbations, on utilise couramment plusieurs types de protection. Pour protéger les câbles contre les émissions extérieures, on prévoit couramment un conducteur extérieur formant cage de Faraday. La protection des appareils et équipements contre les parasites apportés par un câble ou conducteur est réalisée à l'aide d'un moyen de filtrage à inductance, condensateur et diode, à l'entrée de l'appareil ou équipement. Pour s'opposer aux effets de la foudre, la protection la plus fréquemment utilisée est un parafoudre ou éclateur, ou encore une varistance en parallèle sur le conducteur à protéger. Une varistance est un élément dont la résistance électrique diminue sensiblement lorsque le champ électrique dépasse un seuil déterminé ; dans ce cas, la perturbation est dérivée vers la terre.

On a également proposé un câble comportant entre l'âme et le conducteur extérieur un matériau diélectrique à caractéristiques non-linéaires ou à seuil.

Tous ces moyens ou dispositifs de protection sont relativement complexes, encombrants et onéreux. En outre, le seuil des matériaux à comportement non-linéaire qui sont utilisables est généralement trop élevé pour assurer une protection d'équipements électroniques.

L'invention remédie à ces inconvénients.

Elle est caractérisée en ce que le conducteur ou câble comprenant une âme et un conducteur extérieur entre lesquels se trouve un matériau diélectrique de séparation, ledit matériau est isolant pour des valeurs de champ électrique inférieures à un seuil et est conducteur pour des valeurs de champ électrique supérieures à ce seuil, et en ce que la configuration de l'âme et/ou du conducteur extérieur est telle que le seuil de champ électrique extérieur à partir duquel ledit matériau devient conducteur est sensiblement inférieur au seuil de déclenchement intrinsèque du matériau.

Pour obtenir ce résultat, on utilise de préférence l'effet de pointe, c'est-à-dire l'augmentation locale de champ électrique qui existe au voisinage d'une surface conductrice de faible rayon de courbure. Le facteur de division du seuil de déclenchement est par exemple compris entre 10 et 100.

Avec cette disposition, le choix du matériau à seuil est grandement facilité.

Dans un exemple d'utilisation de l'effet de pointe susmentionné, l'âme et/ou le conducteur central présente des ondulations de faible rayon de courbure. Autrement dit, en section par un plan passant par son axe, l'âme présente des cannelures. C'est le rayon de courbure de chaque ondulation qui détermine le facteur de division du seuil. Si deux ondulations se raccordent par une arête vive, cette dernière peut contribuer à l'effet de pointe, malgré sa plus grande distance au conducteur extérieur. En variante, l'âme présente des arêtes en spirale, comme un pas de vis.

Dans un autre exemple, l'âme présente, en section droite, la forme d'un polygone. Les sommets du polygone sont sur des arêtes qui génèrent l'effet de pointe.

Pour cette dernière réalisation, il est préférable de prévoir plusieurs sections qui se succèdent, en direction longitudinale, identiques entre elles mais décalées d'un angle déterminé, autour de l'axe longitudinal, de façon à homogénéiser la répartition des pointes, c'est-à-dire des emplacements où le champ électrique est localement renforcé. Par exemple, si la section est un polygone à n côtés dont chaque côté est vu du centre sous un angle de 360°/n, le décalage angulaire entre deux sections prismatiques (ou cylindriques à section polygonale) sera avantageusement égal à 360°/2n.

Le matériau à seuil est disposé soit seul, entre l'âme et le conducteur, soit en combinaison avec au moins un autre matériau diélectrique.

Le conducteur constitue, par exemple, un connecteur disposé entre un câble classique et un équipement de réception et/ou d'émission des signaux transmis par le câble.

Dans une autre application, le matériau à seuil constitue au moins un élément de séparation entre l'âme et le conducteur extérieur d'un câble de transport d'énergie ou de signaux électriques.

Le matériau à seuil est de préférence du type organique tel qu'un polymère conducteur ou un zwitterion. Par polymère "conducteur", on entend un polymère qui, tout en étant isolant dans les conditions normales, présente cependant une conductivité supérieure à celle d'un isolant classique. Par exemple, un isolant classique, tel que le polyéthylène, présente une conductivité de 10⁻¹⁵ S/cm, alors qu'un polymère conducteur tel que la polyaniline présente une conductivité de 10⁻¹⁰ S/cm.

D'autres caractéristiques et avantages de l'invention apparaîtront avec la description de certains de ses modes de réalisation, celle-ci étant effectuée en se référant aux dessins ci-annexés sur lesquels :
la figure 1 est un schéma d'un exemple d'utilisation d'un connecteur selon l'invention,
la figure 2 est un schéma en coupe longitudinale d'un mode de réalisation de connecteur selon l'invention,
la figure 3 est une coupe selon la ligne 3-3 de la figure 2,
la figure 4 est un schéma à plus grande échelle d'une partie du dispositif représenté sur la figure 2,
la figure 5 est un schéma analogue à celui de la figure 2, mais pour une variante,
la figure 6 est une coupe selon la ligne 6-6 de la figure 5, et
les figures 7a et 7b sont des coupes selon les lignes, respectivement 7a et 7b, de la figure 5.

L'invention vise à éliminer les perturbations détectées par un câble et dont l'amplitude dépasse un seuil déterminé. Elle concerne, selon un premier aspect, un connecteur disposé entre un câble susceptible de transporter des signaux perturbateurs et un appareil à protéger. Elle concerne aussi, selon un autre aspect, un câble assurant lui-même la fonction de protection.

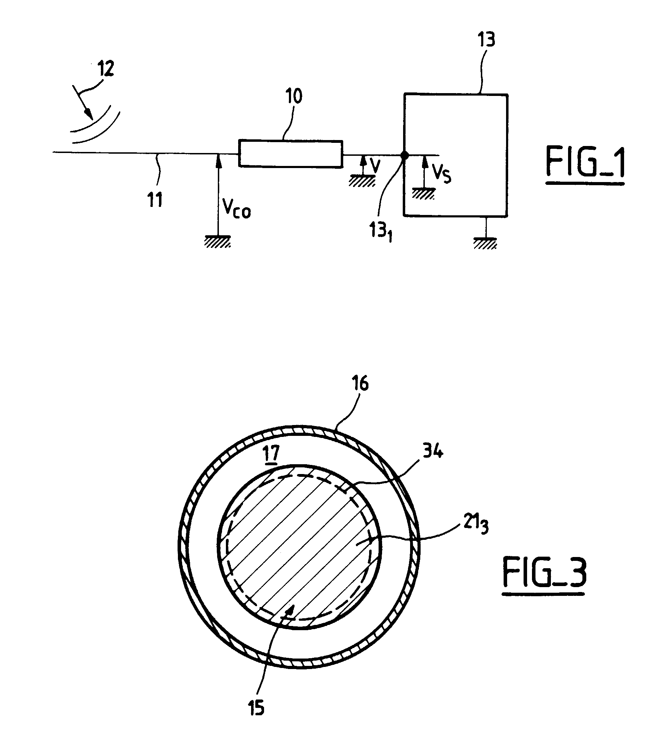

La figure 1 représente un exemple d'utilisation d'un connecteur 10 selon l'invention.

Ce connecteur 10 est disposé entre, d'une part, un câble 11 soumis à une perturbation ou agression électromagnétique 12 et, d'autre part, un appareil ou équipement 13 à protéger. Bien que ce connecteur 10 soit représenté à l'extérieur de l'appareil 13, on comprend aisément qu'il pourrait aussi être logé dans le boîtier de l'appareil 13.

Le câble 11 se comporte en antenne réceptrice pour les ondes extérieures 12. Ces ondes perturbatrices peuvent endommager l'équipement d'extrémité 13 (émission et/ou réception) si elles dépassent un niveau d'énergie, ou seuil de tension, représenté par la flèche Vs à l'entrée 13₁.

Le but du connecteur 10 est d'éliminer, ou de limiter à une tension V, inférieure à Vs, l'amplitude de la perturbation qui provoque, au bout du câble 11, une tension V_{CO} en circuit ouvert qui est sensiblement supérieure à Vs, c'est-à-dire supérieure à la limite de la tension admissible à l'entrée 13₁ de l'équipement 13.

Pour éliminer les perturbations, le connecteur 10 (et/ou, comme on le verra plus loin, le câble 11) fait appel à un matériau à caractéristique non-linéaire disposé entre l'âme et le conducteur extérieur du connecteur 10 (ou du câble 11). Par matériau à "caractéristique non-linéaire", on entend un matériau qui, pour de faibles valeurs de champ électrique, est isolant et qui, à partir d'un certain seuil de champ électrique, devient conducteur.

Dans ces conditions, lorsque le champ électrique dépasse ledit seuil, c'est-à-dire lorsque la perturbation dépasse une valeur déterminée, cette perturbation est dérivée vers la masse ou est dissipée dans le matériau.

Les matériaux à comportement non-linéaire qui peuvent être utilisés pour effectuer la protection sont, par exemple les suivants : du zwitterion ou des polymères tels qu'une polyaniline, le poly(N-phényl P-phénylène diamine), un polythiophène, un polyarylthiophène, un polypyrolle, un polyarylvinylène, un poly(P-phénylène sulfure), un poly(P-phénylène), un paraphénylène vinylène, les copolymères de ces matériaux et leurs mélanges.

On peut également utiliser un copolymère auto-dopé choisi parmi un copolymère du N-phényl P-phénylène diamine avec un acide amino-naphtalène sulfonique, un copolymère de l'aniline avec un acide amino-naphtalène sulfonique, un copolymère de l'aniline avec l'acide 3-(3-aminobenzyloxy)-1-propane sulfonique, un copolymère de l'aniline avec l'acide 3-(2-aminophénoxy)-1-propane sulfonique, un copolymère de l'aniline avec l'acide 4-(2-aminophénoxy)-1-butane sulfonique, un copolymère de l'aniline avec le 1-amino 2, 6-bis (4-sulfobutoxy) benzène, et leurs mélanges.

Ces polymères deviennent conducteurs quand on leur applique un champ électrique supérieur à 3 kilovolts par mm environ. Cette valeur ne convient pas à toutes les applications. En effet, ce seuil est généralement trop élevé pour pouvoir assurer la protection de la plupart des équipements électroniques d'extrémité.

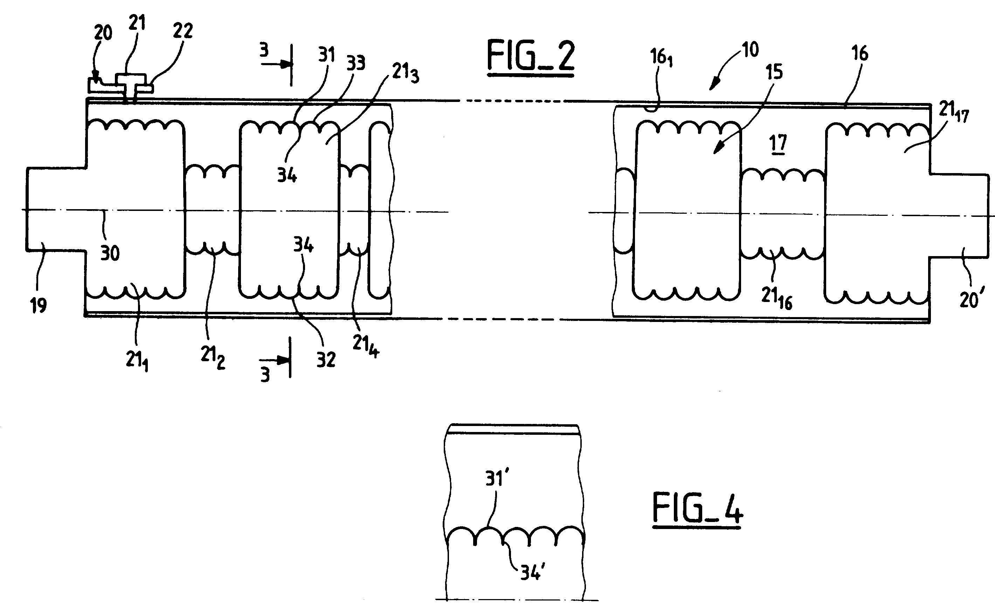

C'est pourquoi, dans le mode de réalisation préféré de l'invention, qui sera décrit en relation avec les figures 2 à 7, on fait appel à l'effet de pointe pour abaisser le seuil. Le facteur de diminution du seuil de déclenchement que l'on peut obtenir avec l'effet de pointe est compris entre 10 et 100.

Le connecteur 10 représenté sur la figure 2 comprend un conducteur central ou âme 15, un conducteur extérieur 16 et, entre l'âme 15 et le conducteur 16, le matériau 17 à caractéristique non-linéaire.

Étant donné la fonction de protection du connecteur 10, il est nécessaire de prévoir un organe 20 solidaire du conducteur extérieur 16 pour la connexion à la masse. Cet organe 20 est par exemple du type à vis 21 et cosse 22.

Le conducteur extérieur 16 a un diamètre de l'ordre de 25 mm.

Chaque extrémité du connecteur 10 présente une saillie de connexion, respectivement 19 et 20', faisant partie du conducteur central. Ces saillies 19 et 20' sont des cylindres de section circulaire.

Entre les saillies 19 et 20', le conducteur central 15 présente une pluralité de sections 21₁, 21₂, 21₃, etc. divisant ainsi le connecteur 10 en cellules successives dont chacune présente une impédance d'entrée de valeur déterminée. Dans l'exemple, chaque cellule de rang impair (21₁, 21₃, etc.) a une impédance d'entrée de 6 ohms, et chaque cellule de rang pair (21₂, 21₄, etc.), a une impédance d'entrée de 60 ohms. Les longueurs des cellules de rang impair sont toutes les mêmes, alors que les longueurs des cellules de rang pair sont variables. Le but de cette division en cellules est de permettre un filtrage en fréquence des perturbations, entre 10 kilohertz et 18 gigahertz.

Les sections 21₁, 21₃, etc. de rang impair de l'âme 15 ont, dans l'exemple, un rayon maximum de 10,1 mm, tandis que les sections de rang pair 21₂, 21₄, etc. ont un rayon maximum de 2,8 mm.

Pour obtenir l'effet de pointe, c'est-à-dire un abaissement notable du seuil de déclenchement à partir du seuil du matériau 17, la surface extérieure de l'âme forme au moins un tore dont la section par un plan contenant l'axe 30 du connecteur 10 se termine par deux demi-cercles 31, 32 (figure 2) qui, dans l'exemple, ont un rayon de 0,2 mm tant pour les sections de rang pair que pour les sections de rang impair. Sur la figure 4, qui est une demi-section, on a représenté les ondulations 31' de l'âme d'une cellule de rang pair.

Chaque section de l'âme 15 comporte plusieurs de ces éléments ou disques. Ainsi, la surface extérieure de chaque section forme des ondulations, chaque ondulation étant un demi-cercle s'étendant sur une longueur, parallèlement à l'axe, de 0,4 mm. Deux demi-cercles successifs 31 et 33 se rejoignent selon une arête vive, rentrante, 34 (34' sur la figure 4). L'effet de pointe dépend du rayon de courbure des ondulations 31, 33, etc. et de leur distance à la surface interne 16₁ du conducteur extérieur 16. Il dépend aussi de l'arête 34 (34') et de sa distance à la surface 16.

Dans l'exemple représenté sur la figure 2, on voit que les sections 21₁ et 21₃ comportent 5 ondulations, la section 21₂ comporte deux ondulations pleines et une demi-ondulation et la section 21₄ comprend une ondulation et une fraction d'une autre ondulation.

En variante (non montrée), on remplace les ondulations ou cannelures par des nervures en spirale, par exemple à arêtes vives, ces nervures étant analogues (ou identiques) à des pas de vis.

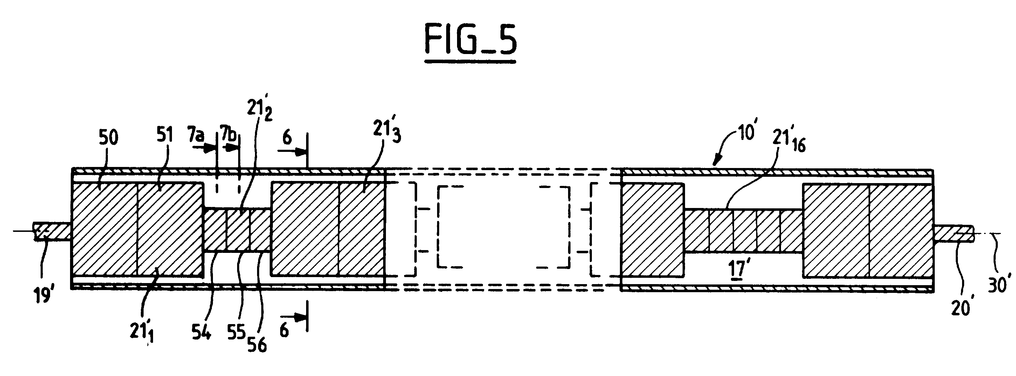

On va maintenant décrire en relation avec les figures 5, 6, 7a et 7b, une variante de connecteur 10. Sur ces figures, les éléments qui sont analogues à des éléments du mode de réalisation représenté sur les figures 2 à 4 portent les mêmes chiffres de référence mais généralement affectés de l'indice prime (').

Pour cette variante, on ne décrira que les éléments qui diffèrent substantiellement de ceux du mode de réalisation précédemment décrit.

Dans cet exemple, l'effet de pointe est obtenu en conférant à la section droite de l'âme, entre les saillies d'extrémité 19' et 20', une forme de polygone, de préférence régulier. Dans l'exemple représenté, le polygone présente douze côtés.

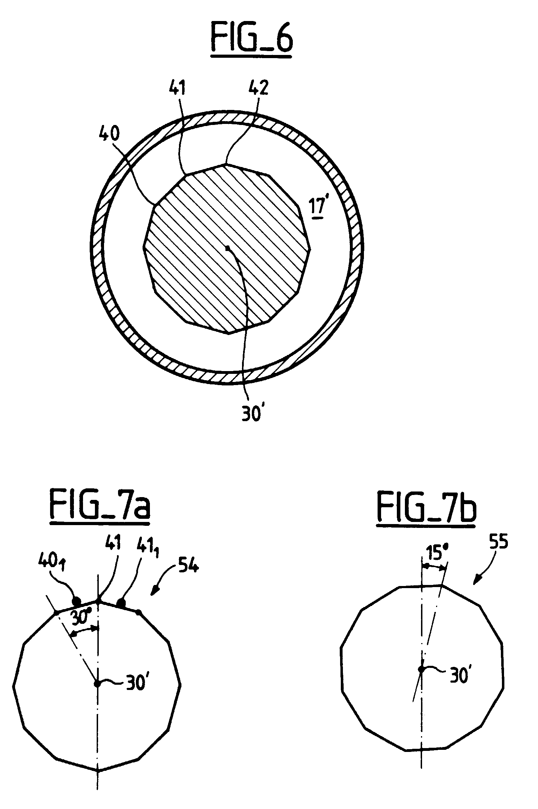

Ce sont les sommets 40, 41, etc. (figure 6) du polygone, c'est-à-dire les arêtes correspondantes (parallèles à l'axe 30'), qui provoquent l'effet de pointe désiré.

Une augmentation locale du champ électrique apparaissant au voisinage des arêtes 40, 41, 42, etc., ces arêtes et leur voisinage, notamment le diélectrique 17', sont soumises à des échauffements locaux. De plus, des arcs électriques indésirables peuvent se produire entre ces arêtes et le conducteur extérieur. Pour limiter ces échauffements localisés, et, surtout, éviter les arcs électriques, on divise chaque section de l'âme en plusieurs sous-sections, de façon telle que deux sous-sections successives présentent un décalage angulaire, autour de l'axe 30', tel qu'une arête d'une sous-section 54 (figure 7a) ne soit pas en prolongement d'une arête de la sous-section suivante 55 (figure 7b), mais à égale distance de deux arêtes voisines de la section adjacente. Dans l'exemple, le décalage angulaire entre deux sous-sections successives 54 et 55 est de 15°. Ce décalage de 15° correspond au demi-angle au sommet sous lequel est vu chaque côté du polygone à partir du centre 30' (figure 7a).

Ainsi, sur la figure 7a, on voit qu'un sommet 41 de la sous-section 54 est entouré par deux sommets 40₁ et 41₁ de la sous-section suivante 55 (sur la figure 7a, les sommets 40₁ et 41₁ ne se trouvent pas dans le même plan que le sommet 41).

Dans l'exemple, la section 21'₁ est formée de deux sous-sections 50 et 51, la section 21'₂ est formée de trois sous-sections 54, 55 et 56. On voit aussi qu'une autre sous-section 21'₁₆ (de rang pair) est divisée en cinq sous-sections.

Les sous-sections d'une même parité ont la même longueur. Cette disposition facilite la réalisation des sections car chacune d'elle est alors formée par association d'éléments constitutifs identiques.

Dans les exemples décrits en relation avec les figures 2 à 7, l'effet de pointe, permettant d'abaisser le seuil de champ électrique à partir duquel le matériau 17 est conducteur, est obtenu par la configuration du conducteur central. En variante (non montrée), les pointes, ou parties de rayon de courbure relativement faible, sont formées sur la face interne du conducteur extérieur. On peut aussi trouver des pointes à la fois sur le conducteur central et sur le conducteur extérieur.

Tous les exemples décrits ci-dessus se rapportent à un connecteur 10. Il est cependant possible de réaliser un câble (non montré) incorporant la fonction de protection de l'invention. Ce câble, qui de façon classique, comporte une âme et un conducteur extérieur séparés par un matériau diélectrique comprend, comme le connecteur décrit ci-dessus, au moins sur certaines de ses parties, un matériau à effet non-linéaire, c'est-à-dire qui est isolant pour des valeurs de champ électrique inférieures à un seuil et est conducteur pour des valeurs de champ électrique supérieures à ce seuil.

Il est également préférable, dans le cas d'un câble, de prévoir des moyens générateurs d'effet de pointe, afin d'abaisser le seuil de déclenchement dudit matériau entre l'âme et le conducteur extérieur.

L'effet de pointe est obtenu par une configuration de l'âme et/ou du conducteur extérieur, de préférence la configuration de l'âme. Comme pour un connecteur, le conducteur central comporte soit des ondulations, soit une nervure analogue à un pas de vis, soit des arêtes longitudinales (section polygonale).

Si le matériau à seuil est associé à une couche isolante, l'effet de protection est obtenu, pour les hautes fréquences, par augmentation de la capacité entre âme et conducteur.

## Revendications

1. Dispositif de transport d'énergie électrique ou de signal électrique comprenant une âme (15, 15'), un conducteur extérieur (16, 16') et, entre l'âme et le conducteur extérieur, un matériau diélectrique à seuil, caractérisé en ce que le matériau diélectrique comprend, au moins en partie, un matériau (17, 17') qui est isolant lorsque le champ électrique est inférieur à un seuil déterminé et est conducteur quand le champ électrique dépasse ce seuil, de façon à empêcher la transmission de signaux pour lesquels le champ électrique est supérieur audit seuil, et en ce que la configuration de l'âme et/ou du conducteur extérieur est telle que le seuil de champ électrique extérieur à partir duquel le matériau devient conducteur est sensiblement inférieur au seuil de déclenchement intrinsèque du matériau.

2. Dispositif selon la revendication 1, caractérisé en ce que l'âme et/ou le conducteur extérieur présente(nt) une configuration à pointe(s) permettant d'augmenter localement la valeur du champ électrique.

3. Dispositif selon la revendication 2, caractérisé en ce que l'âme (15) présente, en section par un plan axial au moins une ondulation (31, 32, 33), ou nervure, ou cannelure, de rayon (s) de courbure permettant d'engendrer ledit effet de pointe.

4. Dispositif selon la revendication 3, caractérisé en ce que la surface extérieure de l'âme est formée de tores dont la section par un plan axial est formée de demi-cercles (31, 33).

5. Dispositif selon la revendication 4, caractérisé en ce que tous les demi-cercles (31, 33) ont le même rayon.

6. Dispositif selon la revendication 2, caractérisé en ce que l'âme (15') présente des arêtes parallèles à son axe.

7. Dispositif selon la revendication 6, caractérisé en ce que l'âme (15') a, en section droite perpendiculairement à l'axe (30'), la forme d'un polygone.

8. Dispositif selon la revendication 7, caractérisé en ce que ledit polygone est régulier.

9. Dispositif selon la revendication 8, caractérisé en ce que le polygone présente douze côtés.

10. Dispositif selon l'une quelconque des revendications 6 à 9, caractérisé en ce que l'âme présente des éléments identiques qui se succèdent mais qui sont décalés angulairement autour de l'axe (30') de façon telle que chaque arête d'un élément (54) soit dans une position angulaire intermédiaire entre les positions angulaires des deux arêtes de l'autre élément (55).

11. Dispositif selon la revendication 10, dans lequel le polygone est de type régulier, caractérisé en ce que le décalage angulaire est égal à la moitié de l'angle sous lequel un côté du polygone est vu à partir du centre (30').

12. Dispositif selon l'une quelconque des revendications précédentes, caractérisé en ce que le matériau diélectrique (17, 17') est un polymère conducteur ou un zwitterion.

13. Dispositif selon la revendication 12, caractérisé en ce que le polymère est choisi parmi une polyaniline, le poly(N-phényl P-phénylène diamine), une polythiophène, un polyarylthiophène, un polypyrolle, un polyarylvinylène, un poly(P-phénylène sulfure), un poly(P-phénylène), un paraphénylène vinylène, leurs copolymères et leurs mélanges.

14. Dispositif selon la revendication 12, caractérisé en ce que ledit matériau (17, 17') est un copolymère auto-dopé choisi parmi un copolymère du N-phényl P-phénylène diamine avec un acide amino-naphthalène sulfonique, un copolymère de l'aniline avec un acide amino-naphthalène sulfonique, un copolymère de l'aniline avec l'acide 3-(3-amnobenzyloxy)-1-propane sulfonique, un copolymère de l'aniline avec l'acide 3-(2-aminophénoxy)-1-propane sulfonique, un copolymère de l'aniline avec l'acide 4-(2-aminophénoxy)-1-butane sulfonique, un copolymère de l'aniline avec le 1-amino 2, 6-bis (4-sulfobutoxy) benzène, et leurs mélanges.

15. Dispositif selon l'une quelconque des revendications précédentes, caractérisé en ce qu'il comprend un moyen (20) de connexion du conducteur extérieur (16) à la masse.

16. Application du dispositif selon l'une quelconque des revendications précédentes à la réalisation d'un connecteur (10) disposé entre un câble (11) et l'entrée d'un organe (13) à protéger contre les perturbations (12) provenant dudit câble (11).

17. Application du dispositif selon l'une quelconque des revendications 1 à 15 à la réalisation d'un câble.
